Europäisches Patentamt

European Patent Office

Office européen des brevets

(11) Publication number: **0 173 583**
**B1**

# EUROPEAN PATENT SPECIFICATION

(45) Date of publication of patent specification: **19.12.90**

(51) Int. Cl.⁵: **C 23 C 14/34, C 23 C 14/54**

(21) Application number: **85306186.9**

(22) Date of filing: **30.08.85**

(54) Discharge apparatus.

(30) Priority: **31.08.84 JP 182183/84**
**03.10.84 JP 207530/84**

(43) Date of publication of application:
**05.03.86 Bulletin 86/10**

(45) Publication of the grant of the patent:
**19.12.90 Bulletin 90/51**

(84) Designated Contracting States:
**DE FR GB NL**

(56) References cited:
**EP-A-0 045 822**
**EP-A-0 099 725**
**EP-A-0 173 583**
**DE-A-2 321 665**
**DE-A-2 707 144**
**DE-A-2 800 852**
**GB-A-2 127 043**
**US-A-4 417 968**
**US-A-4 422 916**
**US-A-4 443 318**
**US-A-4 444 643**

(73) Proprietor: **ANELVA CORPORATION**
**8-1 Yotsuya 5-chome**
**Fuchu-shi Tokyo 183 (JP)**

(72) Inventor: **Kim, Kyungshik c/o Anelva**
**Corporation**
**8-1, Yotsuya 5-chome**
**Fuchu-shi 183 Tokyo (JP)**
Inventor: **Wilkinson, Owen c/o Anelva**
**Corporation**
**8-1, Yotsuya 5-chome**
**Fuchu-shi 183 Tokyo (JP)**

(74) Representative: **Crisp, David Norman et al**
**D. YOUNG & CO. 10 Staple Inn**
**London, WC1V 7RD (GB)**

# Description

The present invention relates to apparatus for performing a discharge reaction process such as film deposition, etching, cleaning, surface hardening and the like on the surface of an object to be processed by using gas plasma generated by vacuum discharge.

A typical conventional apparatus involves discharge using a diode system. In such apparatus, for example, when the process is performed by placing an object to be processed on an unearthed electrode, an increased plasma density resulting from an increase in the electric power applied to the diode in order to increase processing speed, results in an increase in the self-bias voltage at the unearthed electrode and a greater ion bombardment which may cause great damage to the object to be processed. Therefore, the upper value of the power supplied to the electrode has to be limited, thereby limiting the processing speed.

DE—A1—2,707,144 discloses a cathodic sputtering apparatus having at least one electrode and means for generating a magnetic field, however, the described arrangement produces magnetic field lines in an arc-like configuration perpendicular to the surface of the electrode, and in order to improve the distribution of the plasma thus generated, the magnetic field pattern is moved in an oscillatory fashion along the surface of the electrode or the strength of the field is varied by varying the current applied to the electromagnetic coils.

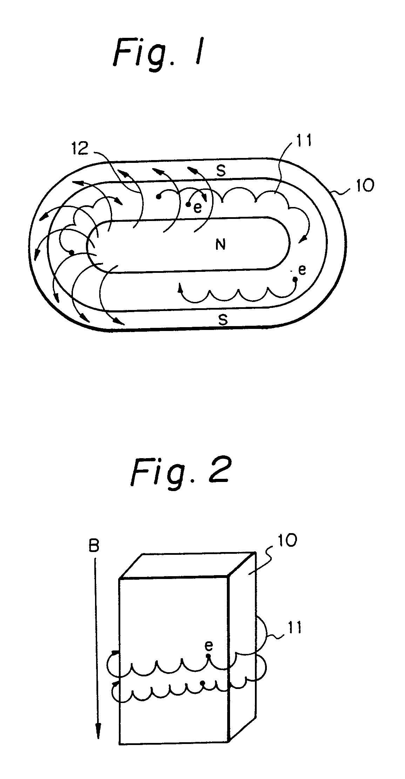

In order to avoid the above-mentioned problems, it has been proposed to generate a magnetic field in parallel to the surface of the electrode, or so as to cover the surface of the electrode, and a high density discharge plasma is generated near the electrode with the aid of this magnetic field, and the object is processed with this plasma. In this case, the discharge plasma is generated by a pseudo-cycloid motion caused by bending the motion of an electron with the magnetic field and repeating a collision of the electron with a wall of the electrode. Typical conventional apparatus utilizing the phenomenon are schematically shown in Figs. 1 to 3 of the accompanying drawings in which reference number 10 shows an electrode, 11 shows the pseudo-cycloid motion of an electron *e*, 12 shows a magnetic line of force, B shows the direction of the magnetic field, and 13 shows a vacuum vessel. In Figs. 1 and 2 the vacuum vessel is not shown.

In pseudo-cycloid motion 11, the electron *e* circulates in the direction shown along the surface or the periphery of the electrode 10, that is, electron *e* moves along and/or around the electrode 10. The direction of circulating motion is determined by the direction of the magnetic field and the direction of a DC electric field. That is, the electron *e* circulates in a clockwise direction along tracks on the surface of the flat electrode 10 in an endless manner in Fig. 1, circulates around the pillar electrode 10 in an endless manner as shown in Fig. 2, and circulates in a clockwise direction along the inner wall of the vacuum vessel 13 and a plurality of electrodes 10 which are provided in the vacuum vessel 13 so as to cover the inner wall, in an endless manner as shown as Fig. 3.

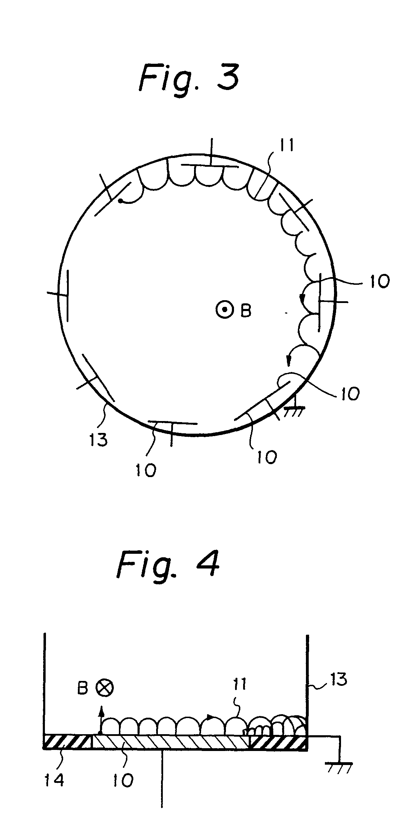

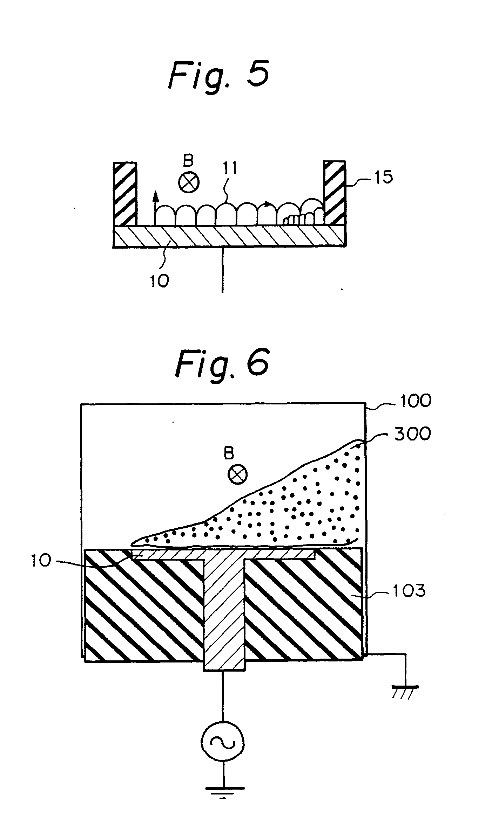

If the circulating motion of the electrons with their pseudo-cycloid motion along the surface of the periphery of the electrode 10 is stopped or limited and the pseudo-cycloid motion of the electrons is performed on only the desired surface of the electrode 10 as shown in Figs. 4 and 5 of the accompanying drawings, then plasma with high density will be obtained and thus a high speed process results. The apparatus as shown in Figs. 4 and 5, however, has not yet been prepared. In Figs. 4 and 5, reference numeral 14 is an insulator and 15 is a barrier formed by an insulator. These insulators serve to limit or stop the circulating motion of the electrons.

The reason why the apparatus shown in Figs. 4 and 5 has not been produced is that the circulating motion of the electrons is limited in one direction as described above, and if the barrier member for stopping or limiting the circulating motion of the electrons is present, the electrons collide with the barrier member causing the electrons to skip or jump but they cannot circulate in the opposite direction and thus circulate in the original direction thereby staying near the barrier member, as shown in Fig. 6. The density distribution of the plasma 300 becomes large in gradient, that is, non-uniform and thus the processing of the object subjected to this plasma is itself-non-uniform.

We have now found it possible to avoid the above described disadvantage of conventional discharge reaction apparatus. In particular, we have been able to provide a discharge reaction apparatus capable of generating plasma with high density and superior uniformity near and along the surface of an electrode, thereby resulting in a process with high quality and high speed.

According to the present invention there is provided a discharge reaction apparatus comprising a vacuum vessel (100) incorporating at least one electrode (101) therein, means (108, 121, 122, 123) for introducing a given amount of gas into the vacuum vessel (100), means (110) for controlling the pressure in the vacuum vessel (100), means (125, 127) for generating a discharge in the vacuum vessel (100) by applying electric power to the electrode(s) (101) thereby to process an object (102) in the vacuum vessel, means to limit or stop any endless circulating motion of electrons which circulate the electrode (101) in an endless manner, and means (104, 105, 106) for generating a dynamic magnetic field along a flat surface portion of the electrode (101), characterised in that the magnetic field lines are produced parallel to and along the flat surface portion of the electrode (101), and in that the dynamic magnetic field is a rotating magnetic field or an alternating magnetic field.

The dynamic magnetic field may be a rotating magnetic field in a circular, elliptic or any other shape. The dynamic magnetic field may be a sinusoidal, triangular, rectangular or any other shape alternating field.

Means for generating the rotating magnetic field may conveniently comprise three pairs of excitation coils arranged so that each pair of excitation coils is disposed diametrically opposite with respect to the vacuum vessel, and each phase current of a three phase alternating current source is applied to these excitation coils, thereby generating the rotating magnetic field. Means for generating the rotating magnetic field preferably comprises three excitation coils so arranged that the coils are disposed diametrically through an axis of the vacuum vessel, and each phase current of a three phase alternating current is applied to the excitation coils thereby generating the rotating magnetic field. Means for generating an alternating field may comprise two excitation coils so arranged that the electrode is disposed between the excitation coils, and an alternating current is applied to the excitation coils thereby to generate an alternating field parallel to the flat surface of the electrode.

Means to limit or stop the circulating motion of the electrons may conveniently comprise the inner side walls of the vacuum vessel and an upper surface of an insulator embedding the electrode therein. Means to limit or stop the circulating motion of the electrons alternatively takes the form of the electrode itself comprising at least two side walls which have an inclined section in the inside direction. The means for limiting or stopping the circulating motion of the electrons may also take the form of the electrode itself comprising at least two side walls which have an upright section. The means to limit or stop the circulating motion of the electrons may also consist of an insulator embedding the electrode therein, which has at least two upright side walls; or an insulator on the electrode, which has at least two upright side walls.

Various preferred features and embodiments of the invention are hereinafter described by way of non-limiting example with reference to the accompanying drawings, in which:

Figs. 1 to 3 are schematic views showing the motion of electrons in conventional discharge reaction apparatus;

Figs. 4 and 5 are schematic views, in cross-section, showing the motion of electrons when limiting or stopping the circulating motion of electrons in order to increase plasma density;

Fig. 6 is a schematic view, in cross-section, showing the distribution of plasma density in the apparatus shown in Figs. 4 and 5;

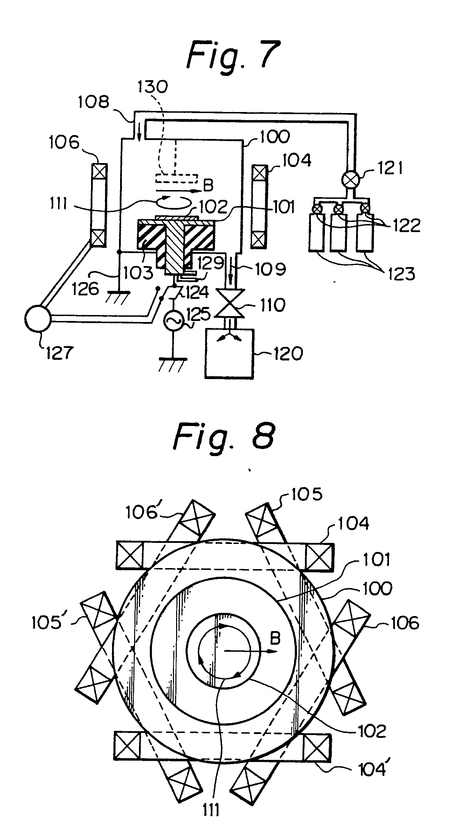

Fig. 7 is a schematic view, partially in cross-section, showing the construction of one embodiment of a discharge reaction apparatus according to the present invention;

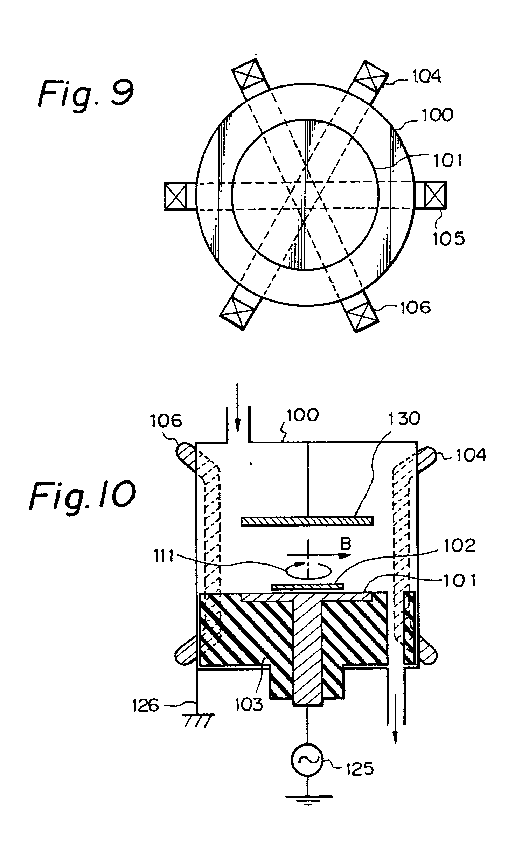

Figs. 8 and 9 are plan views showing an arrangement of electro-magnetic coils for producing a rotating magnetic field;

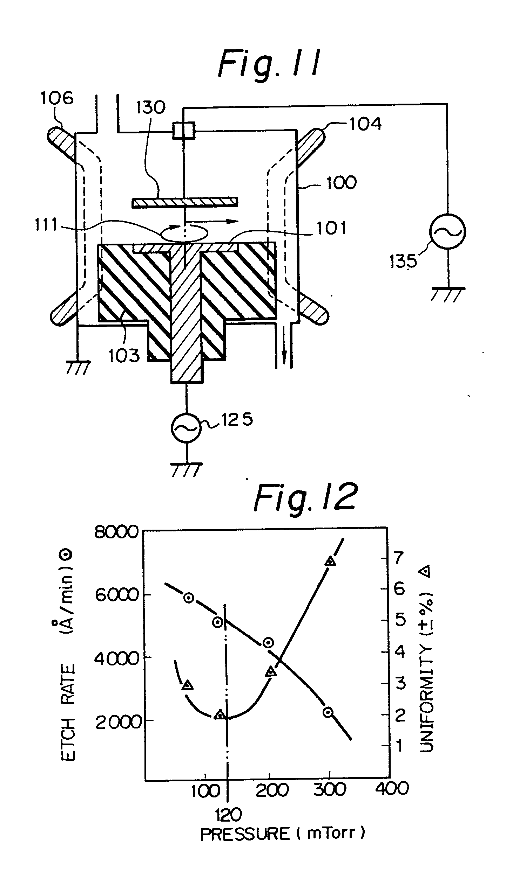

Figs. 10 and 11 are schematic views, partially in cross-section, showing the construction of other embodiments of the discharge reaction apparatus according to the present invention;

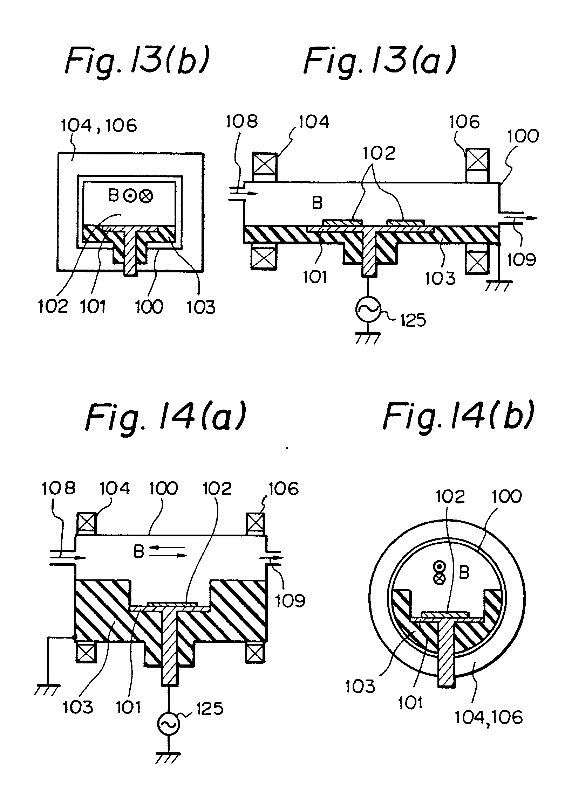

Fig. 12 is a graph showing pressure-etching characteristics of the apparatus shown in Fig. 7;

Figs. 13 to 24 are vertical and transverse sectional views showing the construction of further embodiments of the discharge reaction apparatus according to the present invention;

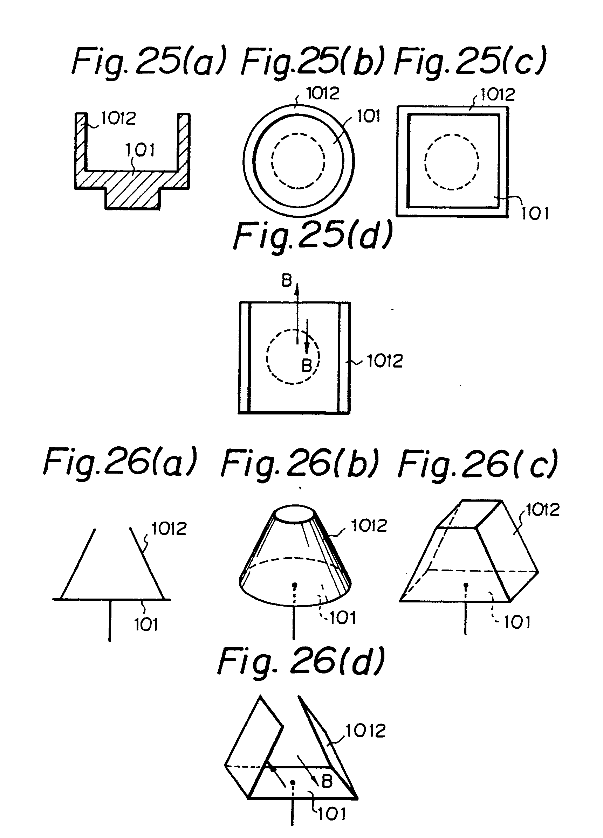

Figs. 25(a) to (d) are sectional and perspective views showing the construction of unearthed electrodes for use in the apparatus according to the present invention;

Figs. 26(a) to (d) are sectional and perspective views showing the construction of other unearthed electrodes for use in the apparatus according to the present invention; and

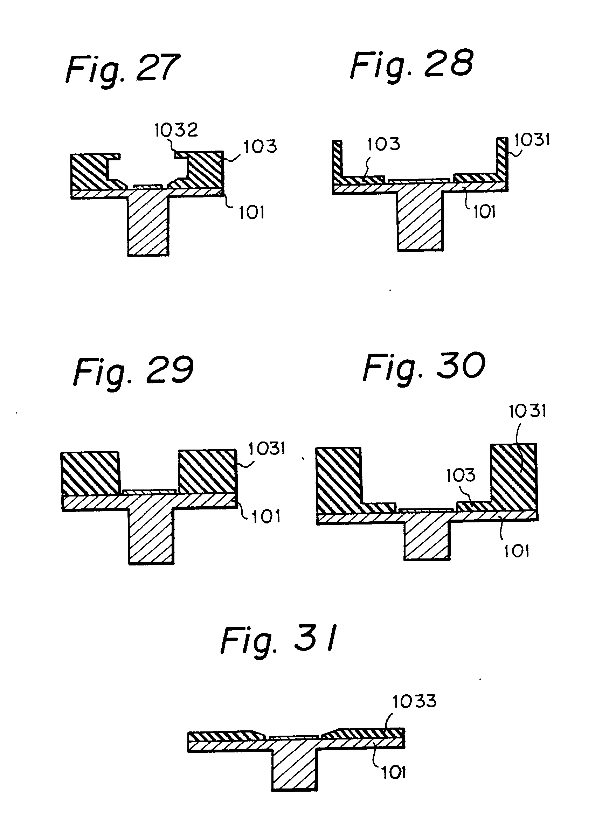

Figs. 27 to 31 are sectional views showing the construction of further unearthed electrodes for use in the apparatus according to the present invention.

Fig. 7 is a schematic view showing the construction of one embodiment of a discharge reaction apparatus according to the present invention.

In Fig. 7 reference numeral 100 shows an earthed metal vacuum vessel in which an object to be processed 102 is placed on an unearthed electrode 101 which is covered by or embedded in an insulator 103 of fluorethylene resin. A processing gas of a predetermined composition is introduced into the vacuum vessel 100 from gas inlet 108 through a variable valve 121 from a plurality of gas vessels 123 each having a valve 122. The processing gas flows over the surface of the electrode 101 and is exhausted from an outlet 109 through a pressure adjusting valve 110 by a pump 120. Reference numeral 126 shows an earthing conduit for the earthed metal vacuum vessel 100.

High frequency electric power is applied between the vacuum vessel 100 and the electrode 101 from a power supply source 125 through a switch 124. At the same time a three phase alternating current or a single phase alternating current is supplied from a supply source 127 through the switch 124 to coils 104 and 106 which are located outside or inside the vacuum vessel 100, thereby producing alternating or rotating magnetic field B parallel to a flat surface portion of the electrode 101. Reference numeral 111 shows one example of the direction of a rotating magnetic field B. The side surface of the insulator 103 prevents electrons from circulating the electrode 101 in a pseudo-cycloid motion. The electrons, however, disperse without staying thereby generating or producing a plasma with a uniform and high density near the flat surface portion of the electrode 101 since the direction of the field B is rotating or alternating. This uniformity means that the mean value of the plasma in time is substantially uniform at all points on the flat surface portion of the electrode. The uniform and high density plasma thus formed means that the object 102 can be treated with high speed and high uniformity. The electrode 101 is also provided with fluid pipe 129 in order to cool the electrode or make thermal adjustments to the electrode.

Where a stationary field B is used, as in conventional apparatus, the speed of processing the object is high, but uniformity is inferior. For example, when $CHF_3$ gas is introduced into the vacuum vessel 100 and $SiO_2$ film on the surface of a 5 inch (13 cm) Si wafer (as the object 102) is etched, the uniformity of etch rate is ±40%. According to the embodiment of the present invention when a three phase alternating current is supplied to the coils 104 and 106 from the supply source 127, the uniformity of etch rate can be increased to ±5%. In this case the etch rate is 5000Å/min or more.

The apparatus shown in Fig. 7 can be used for discharge in a wide pressure range, e.g. of $10^{-5}$-1 Torr thereby producing plasma with high density and high uniformity.

Fig. 12 shows the results of etching obtained when an $SiO_2$ film formed on a Si substrate 102 is etched with a mixed gas of $CHF_3$ and $CO_2$ using the apparatus shown in Fig. 7. In this case, a cylindrical chamber of 400 mm diameter×500 mm is used as the vacuum vessel. Gas flow is 140 standard cubic centimeters, the gas is a mixture of $CHF_3$ with 5% $CO_2$. Flux density of a rectangular alternating field B is 200 gauss with alternation frequency of 20 cycle/min. High frequency power is 650 W with a freqeuncy of 13.56 MHz. The 5 inch (13 cm) diameter substrate is placed on the electrode having a flat surface portion of 200 mm diameter.

Substantially the same result as that described above is obtained by using an alternating magnetic field B produced by the commercially obtained current at 50 Hz.

When the results of etching with the present apparatus, as shown in Fig. 12, are compared with the characteristics of conventional parallel plane apparatus, the uniformity of etching is substantially the same for both apparatus, but the etch rate of the present apparatus is ten times faster than that of conventional apparatus.

As shown in Fig. 12, the best uniformity of ±2.0% is obtained at a pressure of 120 mTorr, and the etch rate of $SiO_2$ is 5100 Å/min. In contrast, with a direct magnetic field the uniformity of the etch rate is ±40%.

The larger the three phase or single phase alternating current applied to the coils 104 and 106, the greater the etching at low pressure so that an etch rate of 7000 Å/min or more may be obtained at a pressure of a few mTorr to a few tenth mTorr.

According to the present invention, a film may be also deposited on the substrate, for example using electrode 130 (used with an earthed or floating potential) placed near electrode 101 and with the introduction of a gas for plasma chemical vapour deposition (CVD) into the vacuum vessel 100. When the substrate 130 is an earthed electrode, the vacuum vessel 100 may be formed of an insulator such as, for example, fluorinated resin, glass or the like.

Examples of gases which may be introduced and the deposited films obtained include:—

$$SiH_4+N_2+NH_3 \rightarrow Si_3H_4 \text{ film}$$

$$SiH_4 \text{ or } Si_2H_6 \text{ etc} \rightarrow a\text{-Si:H film}$$

$$SiH_4+N_2O \rightarrow SiO_2 \text{ film}$$

Quality, uniformity and speed of deposit of the film are the same or superior to those of conventional apparatus, which means that the apparatus shown in Fig. 7 is extremely suitable for use as plasma CVD apparatus.

Figs. 8 to 11 show other embodiments of the apparatus according to the present invention.

In the apparatus shown in Fig. 8, each current phase of a three phase alternating current is supplied to six excitation coils 104 and 104′, 105 an 105′, and 106 and 106′ which encompass the vacuum vessel 100 thereby producing a rotating magnetic field.

In the apparatus shown in Fig. 9, each current phase is supplied to three excitation coils, 104, 105 and 106 thereby producing a rotating magnetic field.

In the apparatus shown in Fig. 10, the electrode 101 is fully embedded in an insulator thereby preventing any circulating motion of the electrons around the electrode 101. In this embodiment, saddle coils are utilized thereby increasing excitation efficiency and minaturizing the apparatus.

In the apparatus shown in Fig. 11, the vacuum vessel 100 is earthed and power is supplied to electrodes 101 and 130 by respective supply sources 125 and 135.

Figs. 13 to 24 show further embodiments of the discharge reaction apparatus according to the present invention.

In the apparatus shown in Figs. 13(a) and 13(b), the upper surface of the insulator 103 forms a barrier to prevent any circulating motion of the electrons and spatially localizes the pseudo-cycloid motion of the electrons on the desired surface of the electrode.

In the apparatus shown in Figs. 14(a) and 14(b), the barrier to prevent any circulating motion of the electrons is formed by side walls of a pit which incorporates electrode 101 therein. The pit is provided in the insulator 103, and the cylindrical vacuum vessel 100 is embedded at the underside of the electrode 101.

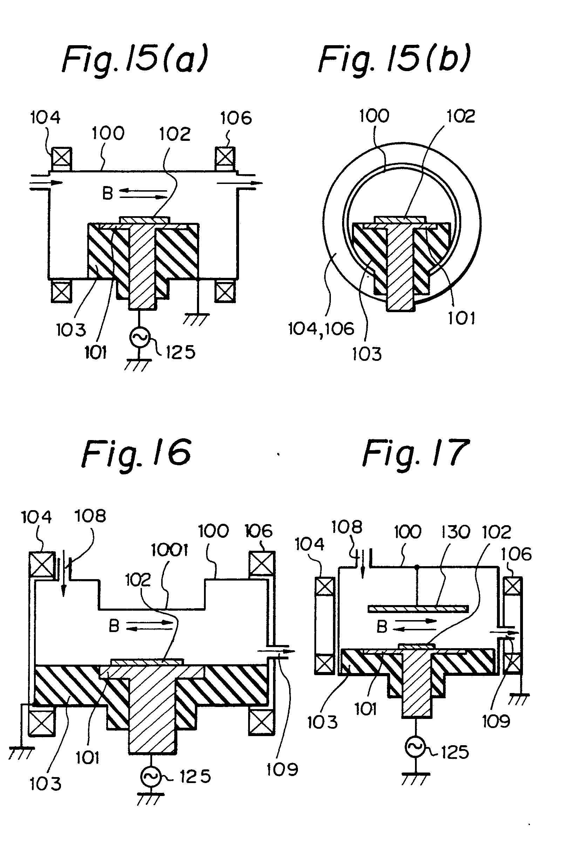

The barrier to prevent any circulating motion of the electrons is formed by the inner side wall at the center of the cylindrical vacuum vessel 100 and the upper surface of the insulator 103 in the apparatus shown in Figs 15(a) and 15(b).

In the apparatus shown in Fig. 16, a recess is provided at a portion 1001 of the vacuum vessel 100 and over the electrode 102 in order to increase power efficiency. The apparatus shown in Fig. 17 is provided with an earthed electrode 130 instead of the recess. Circulating motion of the electrons is prevented by the upper surface of the insulator 103 in both the embodiments shown in Figs. 16 and 17.

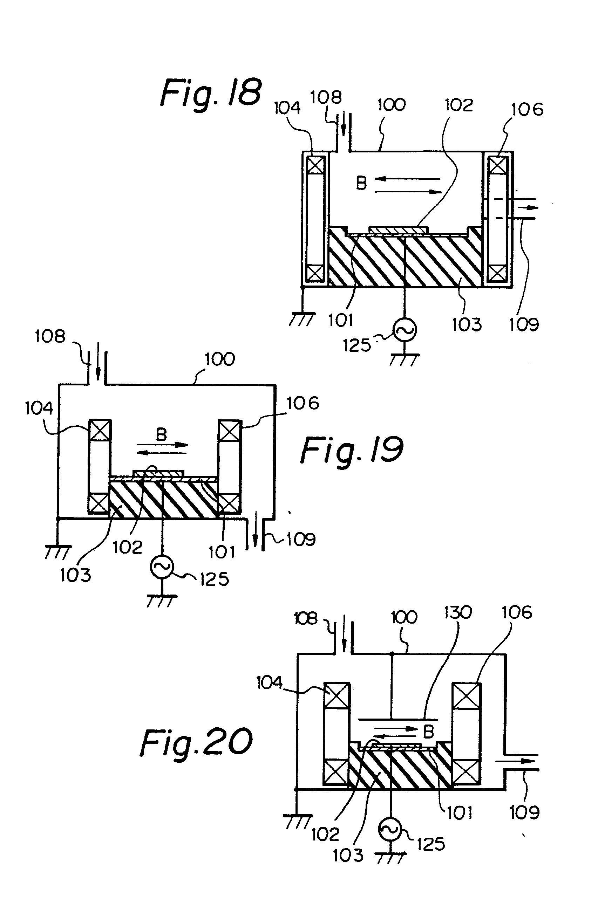

In the apparatus shown in Figs. 18, 19 and 20, the excitation coils 104 and 106 for producing an alternating field B are disposed in the vacuum vessel 100 thereby miniaturizing the apparatus.

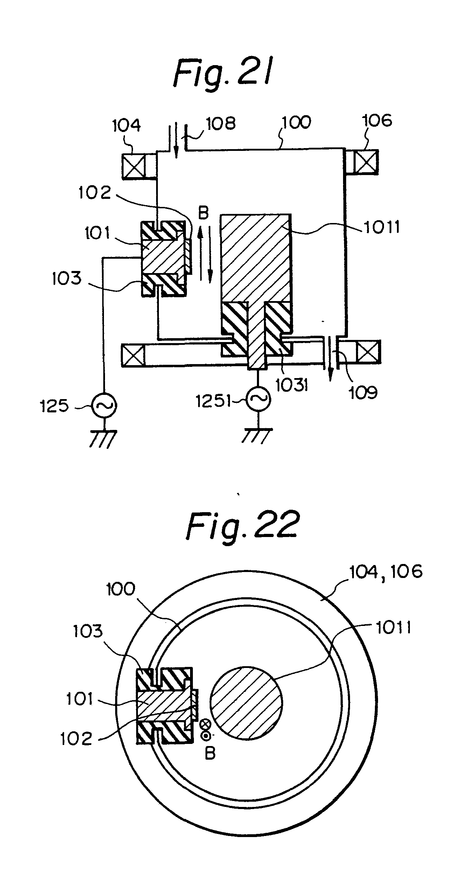

In the embodiments shown in Figs. 21 and 22, the unearthed electrode 101 is mounted at a portion of the side wall of the cylindrical vacuum vessel 100 together with the insulator 103 which prevents circulating motion of the electrons. High frequency power is supplied to the electrode 101 from a supply source 125. At the same time an electrode 1011 for permitting circulating motion of the electrons is also provided in an axial portion of the vessel 100 together with an insulator 1031. High frequency power is supplied to the electrode 1011 from a supply source 1251. Both high frequency power sources may be controlled in frequency and phase.

In the present invention, it is possible to control the process with very high speed (for example, in case of etching $SiO_2$, the etch rate may be 1 μm/min). The uniformity of etch rate may be ±5% for an alternating field B compared to ±40% for an unfluctuating magnetic field.

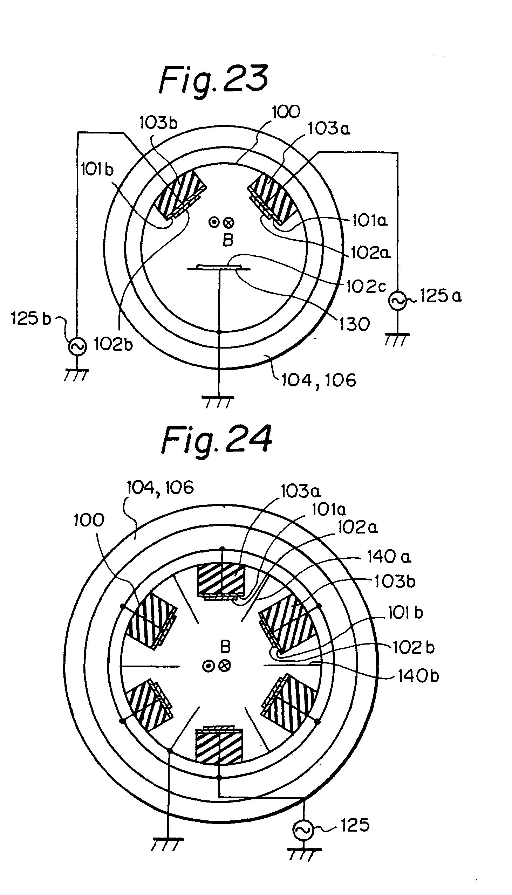

In the apparatus shown in Fig. 23, two electrodes 101a and 101b as well as two insulators 103a and 103b to limit or stop any circulating motion of the electrons are provided in the side wall of the vacuum vessel 100 and the earthed electrode 130 is arranged opposite thereto. The objects to be processed 102a, 102b, or 102c are placed on the electrodes 101a, and 101b and 130.

In the apparatus shown in Fig. 24, six unearthed electrodes 101a, 101b,... are equidistantly arranged on the side wall of the vacuum vessel 100, together with six insulators 103a, 103b,..., respectively. Shield members 140a, 140b,... are provided between the respective electrodes 101a, 101b,... High frequency power is supplied to the respective electrodes 101a, 101b,... from a common supply source 125. In this embodiment the barrier for limiting or stopping any circulating motion of the electrons is formed by the shield member 140 and the side wall of the insulator 103.

Figs. 25 to 31 show means or barriers for limiting or stopping the circulating motion of the electrons.

In the embodiments shown in Figs. 25(a) to 25(d) and 26(a) to 26(d), the barrier is formed by the electrode 101 itself comprising side walls 1012 which have an upright section or a section inclined in the inside direction. These side walls 1012 may be of the same material as that of the electrode 101 and may be made integrally with the electrode. The shape of these side walls 1012 may be formed as shown in Figs. 25(a) to 25(d) and Figs. 26(a) to 26(d).

For example the side wall 1012 of the electrode 101 may be constructed in the form of a right circular cylinder (Fig. 25(b)), a right prism (Fig. 25(c)), parallel planar plates (Fig. 25(d)), a truncated cone (Fig. 26(b)), a truncated prism (Fig. 26(c)), and opposite inclined planar plates (Fig.

26(d)), respectively. Figs. 25(a) and 26(a) are cross sectional views showing the structure of Figs. 25(b) to 25(d) and Figs. 26(b) to 26(d), respectively.

It is possible to repel electrons which collide with the side wall since the electrode has an upright side wall and is biased at a negative voltage so that the plasma density may be increased in the space formed by the side walls and the electrode surface and thus the etch rate of the substrate to be treated can be increased.

According to the embodiment shown in Fig. 26 it is possible to trap or capture emitted electrons by the side wall 1012 without escaping outside the electrode 101 thereby obtaining high plasma density and increasing the etch rate of the substrate to be processed.

In the embodiments shown in Figs. 27 to 30 the barrier is formed by the insulator 103, by which the reflection of electrons is performed.

The insulator 103 may be formed in similar shapes as that of side walls shown in Figs. 25 and 26. Even when using the insulator, electrons are reflected, thereby increasing plasma density and thus etch rate.

The insulator 103 shown in Fig. 27 has projections 1032, by which the reflected electrons are not allowed to escape.

The insulator 103 shown in Fig. 28 has upright edges 1031, by which the plasma density is increased so that high processing speed can be obtained, and uniformity at the edge of the substrate to be processed is improved.

In the embodiment shown in Figs. 29 and 30 the thickness of the insulator is increased thereby trapping the plasma with high density.

In the embodiment shown in Fig. 31 a ringshaped insulator cover 1033 is provided around the substrate to be processed so that a uniform electric field may be obtained on the surfaces of the substrate and the insulator and thus a better uniformity of etching is obtained.

**Claims**

1. A discharge reaction apparatus comprising a vacuum vessel (100) incorporating at least one electrode (101) therein, means (108, 121, 122, 123) for introducing a given amount of gas into the vacuum vessel (100), means (110) for controlling the pressure in the vacuum vessel (100), means (125, 127) for generating a discharge in the vacuum vessel (100) by applying electric power to the electrode(s) (101) thereby to process an object (102) in the vacuum vessel, means to limit or stop any endless circulating motion of electrons which circulate the electrode (101) in an endless manner, and means (104, 105, 106) for generating a dynamic magnetic field along a flat surface portion of the electrode (101), characterised in that the magnetic field lines are produced parallel to and along the flat surface portion of the electrode (101), and in that the dynamic magnetic field is a rotating magnetic field or an alternating magnetic field.

2. A discharge reaction apparatus as claimed in claim 1, wherein means for generating a rotating magnetic field comprises three pairs of excitation coils (104, 104', 105, 105', 106, 106') which are so arranged that each pair of excitation coils are disposed diametrically opposite the vacuum vessel (100), and each current phase of a three phase alternating current is applied to these excitation coils thereby generating the rotating magnetic field.

3. A discharge reaction apparatus as claimed in claim 1, wherein means for generating a rotating magnetic field comprises three excitation coils (104, 105, 106) which are so arranged that these coils are disposed in the diametrical direction through an axis of the vacuum vessel (100), and each current phase of a three phase alternating current is applied to these excitation coils thereby generating the rotating magnetic field.

4. A discharge reaction apparatus as claimed in claim 1, wherein the means for generating an alternating field comprises two excitation coils (104, 106) which are so arranged that the electrode (101) is disposed between the excitation coils (104, 106), and an alternating current is applied to these excitation coils (104, 106) thereby generating the alternating field parallel to the flat surface portion of the electrode (101).

5. A discharge reaction apparatus as claimed in claim 4, wherein the excitation coils are arranged outside the vacuum vessel (100).

6. A discharge reaction apparatus as claimed in claim 4, wherein the excitation coils are arranged inside the vacuum vessel (100).

7. A discharge reaction apparatus as claimed in any one of the preceding claims, wherein the means to limit or stop the circulating motion of the electrons comprises inner side walls of the vacuum vessel (100) and an upper surface of an insulator (103) embedding the electrode (101) therein.

8. A discharge reaction apparatus as claimed in any one of claims 1 to 6, wherein the means to limit or stop the circulating motion of the electrons consists of the electrode (101) itself comprising side walls (1012) which have an upright section.

9. A discharge reaction apparatus as claimed in any one of claims 1 to 6, wherein the means to limit or stop the circulating motion of the electrons consists of the electrode (101) itself comprising at least two side walls (1012) which have a section inclined in the inside direction.

10. A discharge reaction apparatus as claimed in any one of claims 1 to 6, wherein the means to limit or stop the circulating motion of the electrons comprises an insulator (103) embedding the electrode (101) therein, which has at least two upright side walls.

11. A discharge reaction apparatus as claimed in any one of claims 1 to 6, wherein the means to limit or stop the circulating motion of the electrons comprises an insulator (103, 1031) provided on the electrode (101), which has at least two upright side walls.

**Patentansprüche**

1. Entladungsreaktionsgerät mit einem Vakuumbehälter (100), welcher in seinem Innern zumindest eine Elektrode (101) enthält, Einrichtungen (108, 121, 122, 123) zum Eingeben einer vorgegebenen Menge von Gas in den Vakuumbehälter (100), einer Einrichtung zum Steuern des Druckes in dem Vakuumbehälter (100), Einrichtungen (125, 127) zum Erzeugen einer Entladung in dem Vakuumbehälter (100) durch Aufbringen elektrischer Energie auf die Elektrode(n) (101), um dadurch einen Gegenstand (102) in dem Vakuumbehälter zu bearbeiten, einer Einrichtung zum Begrenzen oder Stoppen jeglicher endloser Kreisbewegung von Elektronen, welche die Elektrode (101) in endloser Weise umkreisen und Einrichtungen (104, 105, 106) zum Erzeugen eines dynamischen Magnetfeldes entlang eines ebenen Oberflächenabschnittes der Elektrode (101), dadurch gekennzeichnet, daß die magnetischen Feldlinien parallel zu und entlang des ebenen Oberflächenabschnittes der Elektrode (101) erzeugt werden und daß sich in dem magnetischen Feld ein rotierendes Magnetfeld oder ein magnetisches Wechselfeld vorhanden sind.

2. Entladungsreaktionsgerät nach Anspruch 1, wobei eine Einrichtung zum Erzeugen eines rotierenden Magnetfeldes drei Paare von Erregerspulen (104, 104', 105, 105', 106, 106') aufweist, welche so angeordnet sind, daß jedes Paar von Erregerspulen bezüglich des Vakuumbehälters (100) diametral gegenüberliegend angeordnet ist, und wobei je eine Stromphase eines Dreiphasenwechselstroms auf diese Erregerspulen aufgebracht wird, um dadurch das rotierende Magnetfeld zu erzeugen.

3. Entladungsreaktionsgerät nach Anspruch 1, wobei die Einrichtung zum Erzeugen eines rotierenden Magnetfeldes drei Erregerspulen (104, 105, 106) aufweist, welche so angeordnet sind, daß diese Spulen in diametraler Richtung durch eine Achse des Vakuumgefäßes (100) angeordnet sind und daß je eine Phase eines Dreiphasenwechselstromes auf diese Erregerspulen aufgebracht wird, um dadurch das rotierende Magnetfeld zu erzeugen.

4. Entladungsreaktionsgerät nach Anspruch 1, wobei die Einrichtung zum Erzeugen eines magnetischen Wechselfeldes zwei Erregerspulen (104, 106) aufweist, welche so angeordnet sind, daß die Elektrode (101) zwischen den Erregerspulen (104, 106) angeordnet ist und wobei ein Wechselstrom auf diese Erregerspulen (104, 106) aufgebracht wird, so daß dadurch das Wechselfeld parallel zu dem ebenen Oberflächenabschnitt der Elektrode (101) erzeugt wird.

5. Entladungsreaktionsgerät nach Anspruch 4, wobei die Erregerspulen außerhalb des Vakuumgefäßes (100) angeordnet sind.

6. Entladungsreaktionsgerät nach Anspruch 4, wobei die Erregerspulen innerhalb des Vakuumgefäßes (100) angeordnet sind.

7. Entladungsreaktionsgerät nach einem der vorstehenden Ansprüche, wobei die Einrichtung zum Begrenzen oder Stoppen der Kreisbewegung von Elektronen innere Seitenwände des Vakuumgefäßes (100) und eine obere Oberfläche eines Isolators (103) aufweist, in welcher die Elektrode (101) eingebettet ist.

8. Entladungsreaktionsgerät nach einem der Ansprüche 1 bis 6, wobei die Einrichtung zum Begrenzen doer Stoppen der Kreisbewegung von Elektronen aus der Elektrode (101) selbst besteht, welche Seitenwände (112) aufweist, die einen aufrechten Abschnitt haben.

9. Entladungsreaktionsgerät nach einem der Ansprüche 1 bis 6, wobei die Einrichtung zum Begrenzen oder Stoppen der Kreisbewegung der Elektronen aus der Elektrode (101) selbst besteht, welche zumindest zwei Seitenwände (112) aufweist, die einen in Richtung nach innen geneigten Abschnitt haben.

10. Entladungsreaktionsgerät nach einem der Ansprüche 1 bis 6, wobei die Einrichtung zum Begrenzen oder Stoppen der Kreisbewegung der Elektronen einen Isolator (103) aufweist, in welchen die Elektrode (101) eingebettet ist, die zumindest zwei aufrechte Seitenwände hat.

11. Entladungsreaktionsgerät nach einem der Ansprüche 1 bis 6, wobei die Einrichtung zum Begrenzen oder Stoppen der Kreisbewegung der Elektronen einen Isolator (103, 1031) aufweist, der auf der Elektrode vorgesehen ist, die zumindest zwei aufrechte Seitenwände hat.

**Revendications**

1. Appareil à réaction de décharge comprenant un récipient à vide (100) renfermant au moins une électrode (101), un moyen (108, 121, 122, 123) pour introduire une quantité donnée de gaz dans le récipient à vide (100), un moyen (110) pour contrôler la pression dans le récipient à vide (100), un moyen (125, 127) pour produire une décharge dans le récipient à vide (100) en appliquant de l'énergie électrique sur la ou les électrodes (101) afin de traiter un objet (102) dans le récipient à vide, un moyen pour limiter ou arrêter tout mouvement circulatoire sans fin des électrons qui circulent relativement à l'électrode (101) de manière continue, et un moyen (104, 105, 106) pour créer un champ magnétique dynamique le long d'une portion de surface plate de l'électrode (101), caractérisé en ce que les lignes de force du champ magnétique sont produites parallèlement à la portion de surface plate de l'électrode (101) et le long de celle-ci, et en ce que le champ magnétique dynamique est un champ magnétique rotatif ou un champ magnétique alternatif.

2. Appareil à réaction de décharge selon la revendication 1, dans lequel le moyen pour créer un champ magnétique rotatif comprend trois paires de bobines d'excitation (104, 104', 105, 105', 106, 106') qui sont agencées de sorte que chaque paire de bobines d'excitation soit diamétralement opposée relativement au récipient à vide (100), et chaque courant le phase d'un courant alternatif triphasé est appliqué sur ces bobines d'excitation, créant ainsi le champ magnétique rotatif.

3. Appareil à réaction de décharge selon la revendication 1, dans lequel le moyen pour créer un champ magnétique rotatif comprend trois bobines d'excitation (104, 105, 106) qui sont agencées de sorte que les bobines soien0 de sorte que les bobines soient disposées diamétralement selon un axe du récipient à vide (100), et chaque courant de phase d'un courant alternatif triphasé est appliqué sur ces bobines d'excitation créant ainsi le champ magnètique rotatif.

4. Appareil à réaction de décharge selon la revendication 1, dans lequel le moyen pour créer un champ alternatif comprend deux bobines d'excitation (104, 106) qui sont agencées de sorte que l'électrode (101) soit disposée entre les bobines d'excitation (104, 106), et un courant alternatif est appliqué sur ces bobines d'excitation (104, 106) afin de créer le champ alternatif parallèle à la portion de surface plate de l'électrode (101).

5. Appareil à réaction de décharge selon la revendication 4, dans lequel les bobines d'excitation sont disposées à l'extérieur du récipient à vide (100).

6. Appareil à réaction de décharge selon la revendication 4, dans lequel les bobines d'excitation sont disposées à l'intérieur du récipient à vide (100).

7. Appareil à réaction de décharge selon l'une quelconque des revendications précédentes, dans lequel le moyen pour limiter ou arrêter le mouvement circulatoire des électrons comprend les parois latérales internes du récipient à vide (100) et une surface supérieure d'un isolant (103) renfermant l'électrode (101).

8. Appareil à réaction de décharge selon l'une quelconque des revendications 1 à 6, dans lequel le moyen pour limiter ou arrêter le mouvement circulatoire des électrons consiste en l'électrode (101) même comprenant des parois latérales (1012) qui comportent une section verticale.

9. Appareil à réaction de décharge selon l'une quelconque des revendications 1 à 6, dans lequel le moyen pour limiter ou arrêter le mouvement circulatoire des électrons consiste en l'électrode (101) même comprenant au moins deux parois latérales (1012) qui comportent une section inclinée vers l'intérieur.

10. Appareil à réaction de décharge selon l'une quelconque des revendications 1 à 6, dans lequel le moyen pour limiter ou arrêter le mouvement circulatoire des électrons comprend un isolant (103) renfermant l'électrode (101), qui comporte au moins deux parois latérales verticales.

11. Appareil à réaction de décharge selon l'une quelconque des revendications 1 à 6, dans lequel le moyen pour limiter ou arrêter le mouvement circulatoire des électrons comprend un isolant (103, 1031) prévu sur l'électrode (101), qui comporte au moins deux parois latérales verticales.

# Fig. I

# Fig. 2

## Fig. 3

## Fig. 4

# Fig. 5

# Fig. 6

## Fig. 7

## Fig. 8

Fig. 9

Fig. 10

# Fig. 11

# Fig. 12

Fig. 13(b)

Fig. 13(a)

Fig. 14(a)

Fig. 14(b)

# Fig. 15(a)

# Fig. 15(b)

# Fig. 16

# Fig. 17

Fig. 18

Fig. 19

Fig. 20

# Fig. 21

# Fig. 22

## Fig.23

## Fig.24

## Fig.25(a)  Fig.25(b)  Fig.25(c)

## Fig.25(d)

## Fig.26(a)  Fig.26(b)  Fig.26(c)

## Fig. 26(d)

*Fig. 27*

*Fig. 28*

*Fig. 29*

*Fig. 30*

*Fig. 31*